# EUROPEAN PATENT APPLICATION

(11) **EP 4 389 494 A1**
(43) Date of publication of application: **26.06.2024**
(21) Application number: 22214969.2
(22) Date of filing: 20.12.2022
(51) Int. Cl.: B60L 3/00, B60L 3/04, B60L 3/12, B60L 15/20, B60L 50/64, B60L 50/60, B60L 58/26, H01M 10/625, H01M 50/204, H02J 7/00, G01R 31/382, H01M 10/48, H01M 10/42, H01M 10/613, H01M 10/635

(54) **BATTERY MANAGEMENT SYSTEM AND METHOD FOR ELECTRIC VEHICLES**

(71) Applicant: VOLVO TRUCK CORPORATION, 405 08 Göteborg (SE)
(72) Inventor: AHMED, Istaq, 422 44 Göteborg (SE)
(74) Representative: Ström & Gulliksson AB

(57) **Abstract**

A computer system (200) is provided. The computer system (200) comprises a processor device configured to determine a requested take-off of a parked electric vehicle (1); determine a battery temperature of at least one battery cell (30) of the electric vehicle (1); determine an ambient temperature of the electric vehicle (1); determine a thermal activity state of at least one battery cell (30) as the difference between the battery temperature and the ambient temperature; and prevent the requested take-off of the parked electric vehicle (1) when the thermal activity state is above a predetermined thermal activity state threshold.

## Description

### TECHNICAL FIELD

The disclosure relates generally to vehicles. In particular aspects, the disclosure relates to battery management systems and battery management methods for electric vehicles. The disclosure can be applied in heavy-duty vehicles, such as trucks, buses, and construction equipment, but also in passenger cars. Further, the disclosure can be applied in marine or stationary applications. Although the disclosure may be described with respect to a particular vehicle, the disclosure is not restricted to any particular vehicle.

### BACKGROUND

Vehicles are normally equipped with one or more sub-systems requiring electrical power. In modern vehicles these electric sub-systems are typically propulsion systems whereby the vehicle is either an electrically driven vehicle (i.e. a fully electric vehicle) or a hybrid vehicle (i.e. the driving force is either provided by an electric motor, an internal combustion engine, or both). Within the context of this disclosure, both types are considered being electric vehicles.

Battery energy storage systems are installed in the vehicle in order to provide the required electrical energy to the one or more electrical motors. The battery energy storage system of a modern vehicle typically comprises one battery pack, however a plurality of battery packs may be used in some applications. Each battery pack comprises a plurality of battery modules, and each battery module comprises a plurality of battery cells.

A battery management system is normally connected to the one or more battery packs in order to control energy flow to and from the battery cells. Modern battery management systems are typically also configured to monitor the battery cells in order to determine how much life the battery cells have remaining.

Commercially available battery packs perform at their best within a limited temperature range, such as between 15 and 45°C. Colder temperatures tend to reduce the power output of the battery cells, thereby decreasing the available performance of the associated vehicle. At the other end of the preferred temperature interval, overheating of the battery cells may cause damage to the battery cells, e.g. by thermal runaway.

The battery management system is configured to ensure safety with regards to the battery energy storage system. By monitoring the temperature of the battery energy storage system, the battery management system is programmed to disconnect the battery energy storage system from use if the measured temperature of the battery energy storage system is outside a predetermined safety interval, more specifically if the measured temperature of the battery energy storage system is above a maximum temperature, such as above 55°C. If the battery energy storage system is disconnected, no electric power can be provided to the one or more electrical motors which in practice means that the driver needs to await cooling of the battery energy storage system before use of the vehicle.

One problem with existing vehicles occurs at departing situations. If the vehicle has been parked in a hot climate area, such as in a sunny parking spot during mid-day, there is a risk that the temperature of the battery energy storage system is above the maximum safety temperature. In such situation the battery management system will prevent use of the battery energy storage system, whereby the driver must await natural cooling of the battery energy storage system before being able to depart. With the above-described situation in mind, this may take a very long time.

Based on above, there is a need for improved solutions for battery management systems and methods providing improved usability of the associated vehicle.

### SUMMARY

According to a first aspect of the disclosure, a computer system is provided. The computer system comprises a processor device configured to determine a requested take-off of a parked electric vehicle; determine a battery temperature of at least one battery cell of the electric vehicle; determine an ambient temperature of the electric vehicle; determine a thermal activity state of at least one battery cell as the difference between the battery temperature and the ambient temperature; and preventing the requested take-off when the thermal activity state is above a predetermined thermal activity state threshold. A technical benefit may include improving usability of the vehicle and reduce the risk of unnecessary non-use, especially for vehicles being parked in hot climate areas.

According to a second aspect of the disclosure, a computer-implemented method is provided. The method comprises: determining, by a processor device of a computer system, a requested take-off of a parked electric vehicle; determining, by the processor device, a battery temperature of at least one battery cell of the electric vehicle; determining, by the processor device, an ambient temperature of the electric vehicle; determining, by the processor device, a thermal activity state of at least one battery cell as the difference between the battery temperature and the ambient temperature; and preventing, by the processor device, the requested take-off when the thermal activity state is above a predetermined thermal activity state threshold.

In some examples, the method further comprises allowing, by the processor device, the requested take-off when the battery temperature is above a predetermined battery temperature threshold and when the thermal activity state is below the predetermined thermal activity state threshold. A technical benefit may include more robust usage of the vehicle, as take-off will be allowed even if the vehicle has been parked in a hot climate area.

In some examples, the method further comprises requesting increased cooling of the at least one battery cell. A technical benefit may include allowing a more safe operation at higher temperatures.

In some examples, determining the battery temperature of at least one battery cell of the electric vehicle is performed by means of at least one sensor mounted on at least one battery cell, by means of at least one sensor mounted on at least one battery module, and/or by means of at least one sensor mounted on at least one battery pack. A technical benefit may include the usage of existing components already installed in the vehicle.

In some examples, determining the ambient temperature of at least one battery cell of the electric vehicle is performed by means of at least one ambient sensor mounted remote, or on the exterior, of at least one battery pack. A technical benefit may include the usage of existing components already installed in the vehicle.

In some examples, determining the battery temperature of at least one battery cell of the electric vehicle as an average value of a plurality of battery temperature values. A technical benefit may include providing a more robust control, as an average value is used.

In some examples, determining the battery temperature of at least one battery cell of the electric vehicle as a maximum value of a plurality of battery temperature values. A technical benefit may include providing a more safe control, as a maximum value is used.

In some examples, the method further comprises allowing, by the processor device, the requested take-off when the battery temperature is above a predetermined battery temperature threshold and when the thermal activity state is below the predetermined thermal activity state threshold, wherein determining the battery temperature of at least one battery cell of the electric vehicle is performed by means of at least one sensor mounted on at least one battery cell, battery module, or battery pack, wherein determining the ambient temperature of at least one battery cell of the electric vehicle is performed by means of at least one ambient sensor mounted remote, or on the exterior, of at least one battery pack, wherein preventing) the requested take-off is performed by disconnecting the at least one battery cell, and wherein determining the battery temperature of at least one battery cell of the electric vehicle as an average value or a maximum value of a plurality of battery temperature values.

According to a third aspect of the disclosure, an electric vehicle is provided. The electric vehicle comprises the processor device to perform the method according to the second aspect.

According to a fourth aspect, a computer program product is provided. The computer-program product comprises program code for performing, when executed by the processor device, the method according to the second aspect.

According to a fifth aspect, a control system is provided. The control system comprises one or more control units configured to perform the method according to the second aspect.

According to a sixth aspect, a non-transitory computer-readable storage medium is provided. The medium comprises instructions, which when executed by the processor device, cause the processor device to perform the method according to the second aspect.

The above aspects, accompanying claims, and/or examples disclosed herein above and later below may be suitably combined with each other as would be apparent to anyone of ordinary skill in the art.

Additional features and advantages are disclosed in the following description, claims, and drawings, and in part will be readily apparent therefrom to those skilled in the art or recognized by practicing the disclosure as described herein. There are also disclosed herein control units, computer readable media, and computer program products associated with the above discussed technical benefits.

### BRIEF DESCRIPTION OF THE DRAWINGS

With reference to the appended drawings, below follows a more detailed description of aspects of the disclosure cited as examples.
**FIG. 1** is an exemplary isometric view of a vehicle according to one example.
**FIG. 2** is an exemplary system diagram of a vehicle according to an example.
**FIG. 3** is a flow chart of an exemplary method for an electric vehicle according to one example.
**FIG. 4** is a flow chart of an exemplary method for an electric vehicle according to one example.
**FIG. 5** is a diagram showing temperature variations of a vehicle according to one example.
**FIG. 6** is another exemplary system diagram of a vehicle according to an example.
**FIG. 7** is a schematic diagram of an exemplary computer system for implementing examples disclosed herein, according to one example.

### DETAILED DESCRIPTION

Aspects set forth below represent the necessary information to enable those skilled in the art to practice the disclosure.

The examples presented herein provide a solution to improve usability of vehicles, in particular electrical vehicles such as trucks, etc. By differentiating ambient heating of a battery pack from thermal activity heating of the same, unnecessary disconnection of the battery pack can be avoided and requested operation of the vehicle can still be performed.

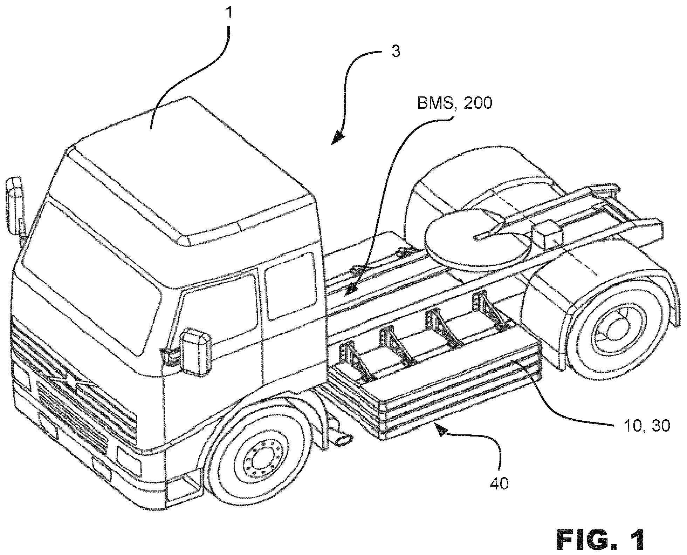

**FIG. 1** is an exemplary side view of a vehicle **1** according to one example. The vehicle **1,** herein the form of a truck, may or may not be an articulated vehicle. The truck **1** comprises a tractor unit **3;** optionally a trailer (not shown) may be provided and being pulled by the tractor unit **3.** The vehicle **1** comprises one or more battery cells **10** arranged to form one or more battery packs **30.** The one or more battery packs **30** form a battery energy storage system **40.** The vehicle **1** further comprises a battery management system **BMS** forming a computer system **200** as will be further described below. The battery management system **BMS** is configured to monitor and control the battery energy storage system **5** based on driver requests and vehicle operation specifics.

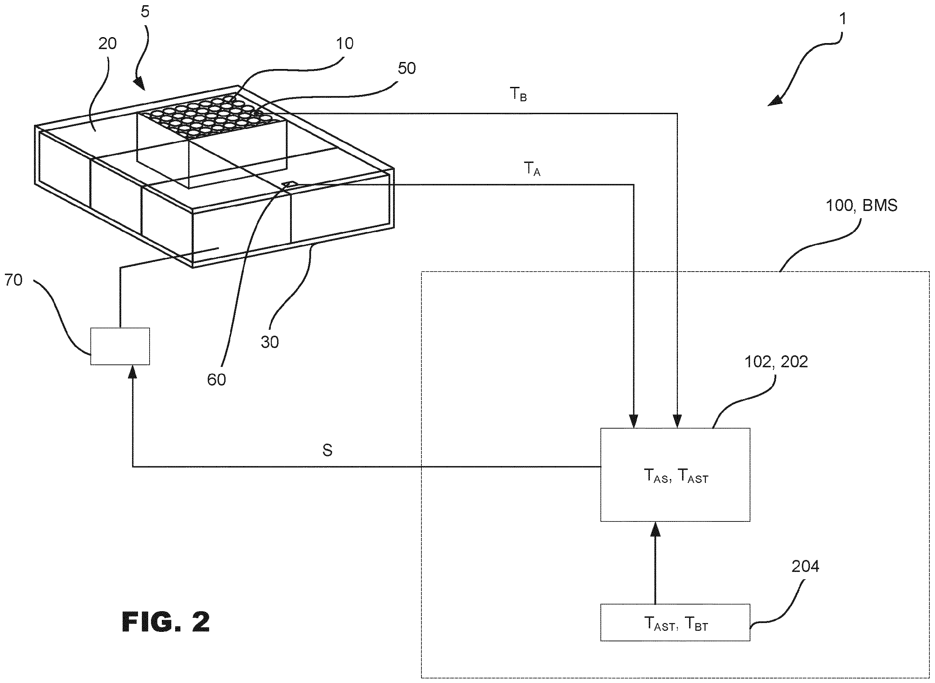

**FIG. 2** shows vehicle **1** in terms of a system diagram of a control system **100** representing the hardware architecture required for controlling take-off with regards to the thermal activity state **T_{AS}** of the at least one battery cell **10.**

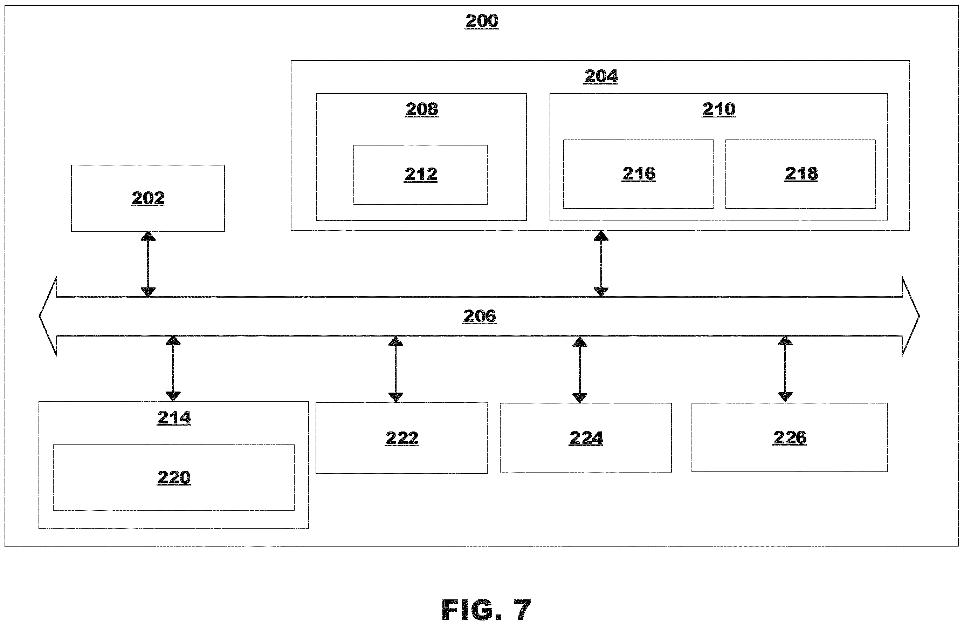

The control system **100** comprises one or more control units **102.** The one or more control units **102** is configured to receive data, and to process the data in order to determine the thermal activity state **T_{AS}** required for controlling operation of the vehicle **1.** The one or more control units **102** may be implemented as a processor device **202,** see **FIG. 7****.**

The control system **100** may constitute, or form part of, the battery management system **BMS.** The control system **100** is configured to determine a battery temperature **T_{B}** of at least one of said battery cells **10,** and to compare the battery temperature **T_{B}** with an ambient temperature **T_{A}** in order to determine a thermal activity state **T_{AS}** of at least one of said one or more battery cells **10.** Preferably, the thermal activity state **T_{AS}** is calculated as the difference between the battery temperature **T_{B}** and the ambient temperature **T_{A}.** For this purpose, the vehicle **1** comprises at least one battery cell temperature sensor **50** and at least one ambient temperature sensor **60.**

As is shown in **FIG. 2****,** the vehicle **1** is provided with a battery energy storage system 5. The battery energy storage system **5** comprises a plurality of battery cells **10.** A specific number of battery cells **10** are arranged in a battery module **20,** and a plurality of battery modules **20** form a battery pack **30.**

The battery cell temperature sensor **50** is preferably arranged in direct contact with a battery cell **10** and is connected to the one or more control units **102** such that sensor signals, representing the actual battery temperature **T_{B}** of at least one battery cell **10,** are received by the one or more control units **102.**

The ambient temperature sensor **60** is preferably arranged remote from the battery cells **10,** such as at an exterior side of the battery pack **30,** and it is connected to the one or more control units **102** such that sensor signals, representing the actual ambient temperature **T_{A},** are received by the one or more control units **102.**

The one or more control units **102** may receive sensor data continuously, or preferably at least when a take-off of the associated vehicle **1** is requested by a driver.

The vehicle **1** is configured to allow take-off if the thermal activity state **T_{AS}** is below a predetermined thermal activity state threshold **T_{AST},** and to prevent take-off if the thermal activity state **T_{AS}** is above the predetermined thermal activity state threshold **T_{AST}.**

The control system **100** may thus comprise, or be connected to, at least one memory **204.** The memory **204** is programmed to store a value representing the activity state threshold **T_{AST},** and to communicate said value to the one or more control units **102.** The memory unit may also store a value representing a battery temperature threshold **T_{BT},** and to communicate said value to the one or more control units **102.**

Upon receipt of the activity state threshold **T_{AST},** the one or more control units 102 performs a comparison between the thermal activity state **T_{AS},** i.e. preferably the temperature difference between the battery temperature **T_{B}** and the ambient temperature **T_{A}.**

Take-off is preferably prevented by the control unit **100** being configured to transmit a control signal **S** to a battery junction box **70,** which upon receipt of the control signal S disconnects the battery energy storage system **5** from components, such as power electronics and electrical motors (not shown) of the vehicle **1.**

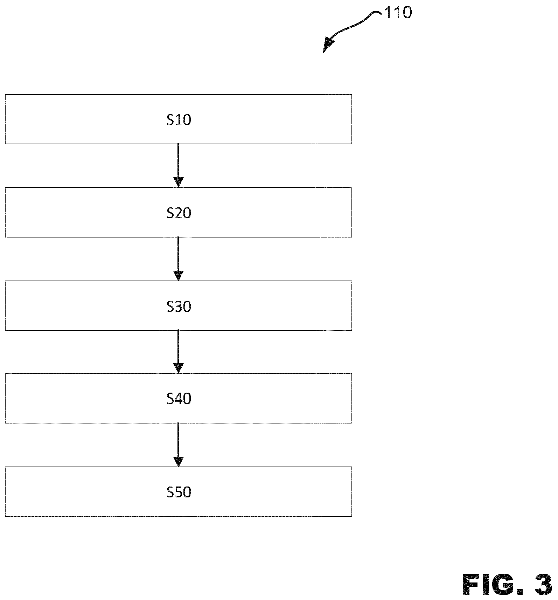

In **FIG. 3** a method **110** is schematically shown. The method **110** is a computer-implemented method for controlling availability of the battery energy storage system **5** of the vehicle 1 before take-off, or departure from a parked position.

The method **110** comprises determining **S10,** by a processor device **202** of a computer system **200,** a requested take-off of a parked electric vehicle **1.** The method further comprises determining **S20,** by the processor device **202,** a battery temperature **T_{B}** of at least one battery cell **10** of the electric vehicle **1** and determining **S30,** by the processor device **202,** an ambient temperature **T_{A}** of the electric vehicle **1.** The method further comprises determining **S40,** by the processor device **202,** a thermal activity state **T_{AS}** of at least one battery cell **30** as the difference between the battery temperature **T_{B}** and the ambient temperature **T_{A}.** The method further comprises preventing **S50,** by the processor device **202,** the requested take-off when the thermal activity state **T_{AS}** is above a predetermined thermal activity state threshold **T_{AST}.**

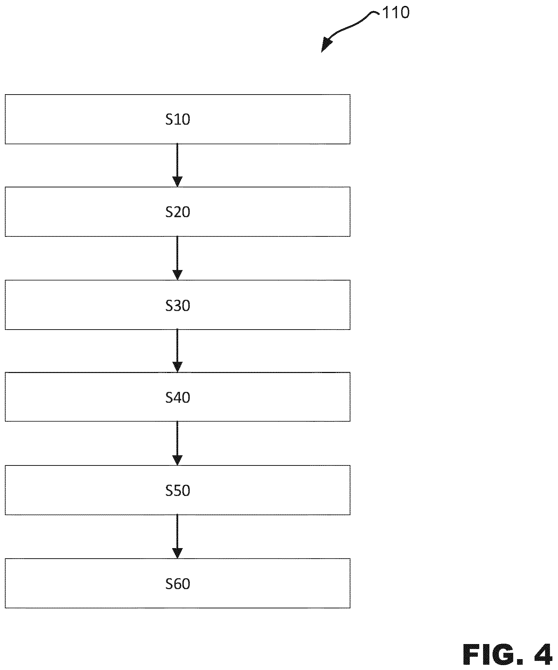

**FIG. 4** shows an exemplary method **110** according to one example. The method **110** is a computer-implemented method for controlling availability of the battery energy storage system **5** of the vehicle **1** before take-off, or departure from a parked position.

The method **110** comprises determining **S10,** by a processor device **202** of a computer system **200,** a requested take-off of a parked electric vehicle **1.** Requested take-off may e.g. be determined by a driver unlocking a door of the vehicle **1,** a driver changing gear from a parking gear, and/or a driver entering a desired itinerary for the vehicle **1.**

The method **110** further comprises determining **S20,** by the processor device **202,** a battery temperature **T_{B}** of at least one battery cell **10** of the electric vehicle **1.** The battery temperature **T_{B}** may be determined by means of at least one sensor **50** mounted on at least one battery cell **10,** mounted on at least one battery module **20,** or mounted on at least one battery pack **30.** The battery temperature **T_{B}** may be a single value representing the temperature of a specific part of the battery energy storage system **5,** and/or an average or maximum value of a plurality of battery temperature **T_{B}** values.

The method **110** further comprises determining **S30,** by the processor device **202,** an ambient temperature **T_{A}** of the electric vehicle 1. The ambient temperature sensor **60** may be mounted remote from, or on the exterior of, at least one battery pack **30.**

The method **110** further comprises determining **S40,** by the processor device **202,** a thermal activity state **T_{AS}** of at least one battery cell **30.** The thermal activity state **T_{AS}** is preferably determined as the difference between the battery temperature **T_{B}** and the ambient temperature **T_{A}.**

The method **110** further comprises preventing **S50,** by the processor device **202,** the requested take-off when the thermal activity state **T_{AS}** is above a predetermined thermal activity state threshold **T_{AST}.** Preventing **S50** the requested take-off is preferably performed by disconnecting the at least one battery cell **10,** in some examples the entire battery energy storage system **5,** from the vehicle components requiring electrical power for take-off.

The method **110** further comprises allowing **S60,** by the processor device **202,** the requested take-off when the battery temperature **T_{B}** is above a predetermined battery temperature threshold **T_{BT}** and when the thermal activity state **T_{AS}** is below the predetermined thermal activity state threshold **T_{AST}.**

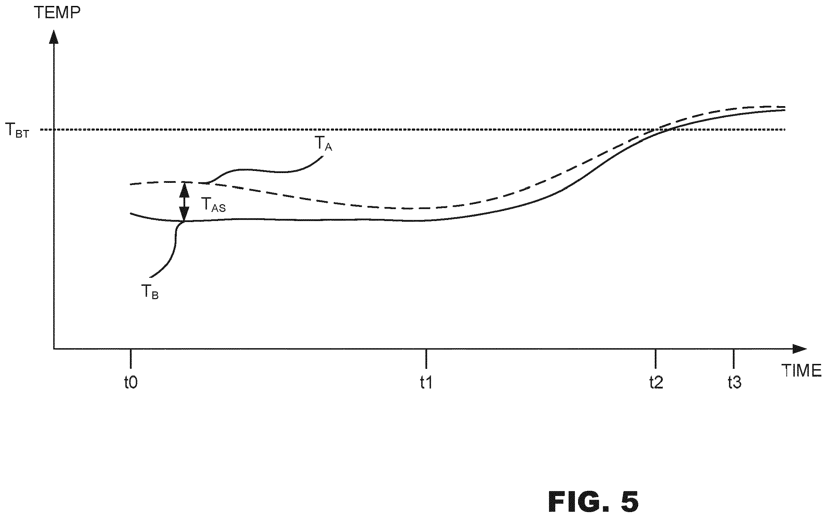

**FIG. 5** shows a diagram illustrating the temperature **T_{B}** of a battery energy storage system **5** over time. Initially, from time **t0,** the battery temperature **T_{B}** fluctuates at a certain level, indicating normal driving of the associated vehicle **1.** The ambient temperature **T_{A}** is during this time slightly above the battery temperature **T_{B}.** At time **t1** the vehicle is parked. The ambient temperature **T_{A}** rises significantly to a level above a predetermined battery temperature threshold **T_{BT}.** Due to ambient heating, the battery temperature **T_{B}** will rise correspondingly. At time **t2** the battery temperature **T_{B}** exceeds the predetermined battery temperature threshold **T_{BT}.** At time **t3** the driver requests take-off of the vehicle **1.** According to prior art, such request would not be allowed since the battery temperature **T_{B}** is beyond the predetermined maximum battery temperature threshold **T_{BT}.** However, according to the examples given herein the battery temperature **T_{B}** is compared with the ambient temperature **T_{A}** in order to define a thermal activity state **T_{AS}** of the battery energy storage system 5. Only when the thermal activity state **T_{AS}** exceeds the predetermined thermal activity state threshold **T_{AST},** take-off is prevented. In the example shown in **FIG. 5** the thermal activity state **T_{AS},** i.e. the difference between the battery temperature **T_{B}** and the ambient temperature **T_{A},** is very small and slightly below zero (as the ambient temperature **T_{A}** is higher than the battery temperature **T_{B}**). Preferably, the predetermined thermal activity state threshold **T_{AST}** is a positive value in the range of 10-50°C depending on the specific types of battery cells **10** used. This means that in the present example the driver will be allowed to depart from the parked position as the thermal activity state **T_{AS}** is small and below the predetermined thermal activity state threshold **T_{AST}.**

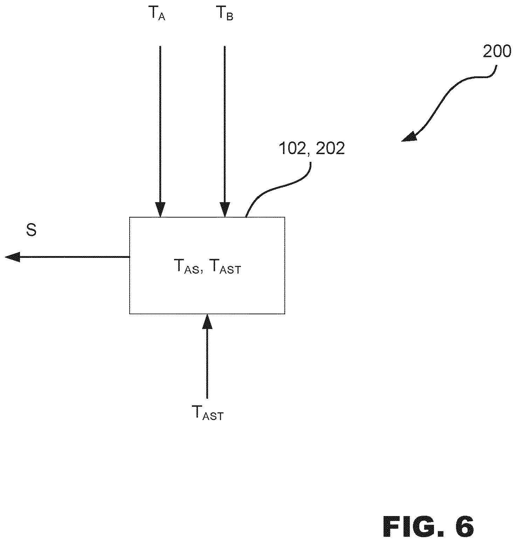

**FIG. 6** is another view of **FIG. 2** according to another example. A processor device **202** is forming part of a computer system **200** of a vehicle **1.** The processor device **202** may represent one or more control units **102,** and the computer system **200** may represent a control system **100.** The processor device **202** is configured to receive a battery temperature **T_{B}** and an ambient temperature **T_{A},** and to determine a thermal activity state **T_{AS}** of an associated battery energy storage system **5** based on the battery temperature **T_{B}** and an ambient temperature **T_{A}.**

The processor device **202** is further configured to compare the thermal activity state **T_{AS}** with a predetermined thermal activity state threshold **T_{AST}.** If the thermal activity state **T_{AS}** is above the predetermined thermal activity state threshold **T_{AST}** the processor device **202** is further configured to prevent take-off of the vehicle **1.**

**FIG. 7** is a schematic diagram of a computer system **200** for implementing examples disclosed herein. The computer system **200** is adapted to execute instructions from a computer-readable medium to perform these and/or any of the functions or processing described herein. The computer system **200** may be connected (e.g., networked) to other machines in a LAN, an intranet, an extranet, or the Internet. While only a single device is illustrated, the computer system **200** may include any collection of devices that individually or jointly execute a set (or multiple sets) of instructions to perform any one or more of the methodologies discussed herein. Accordingly, any reference in the disclosure and/or claims to a computer system, computing system, computer device, computing device, control system, control unit, electronic control unit (ECU), processor device, etc., includes reference to one or more such devices to individually or jointly execute a set (or multiple sets) of instructions to perform any one or more of the methodologies discussed herein. For example, control system may include a single control unit or a plurality of control units connected or otherwise communicatively coupled to each other, such that any performed function may be distributed between the control units as desired. Further, such devices may communicate with each other or other devices by various system architectures, such as directly or via a Controller Area Network (CAN) bus, etc.

The computer system **200** may comprise at least one computing device or electronic device capable of including firmware, hardware, and/or executing software instructions to implement the functionality described herein. The computer system 200 may include a processor device **202** (may also be referred to as a control unit), a memory **204,** and a system bus **206.** The computer system **200** may include at least one computing device having the processor device **202.** The system bus **206** provides an interface for system components including, but not limited to, the memory **204** and the processor device **202.** The processor device **202** may include any number of hardware components for conducting data or signal processing or for executing computer code stored in memory **204.** The processor device **202** (e.g., control unit) may, for example, include a general-purpose processor, an application specific processor, a Digital Signal Processor (DSP), an Application Specific Integrated Circuit (ASIC), a Field Programmable Gate Array (FPGA), a circuit containing processing components, a group of distributed processing components, a group of distributed computers configured for processing, or other programmable logic device, discrete gate or transistor logic, discrete hardware components, or any combination thereof designed to perform the functions described herein. The processor device may further include computer executable code that controls operation of the programmable device.

The system bus **206** may be any of several types of bus structures that may further interconnect to a memory bus (with or without a memory controller), a peripheral bus, and/or a local bus using any of a variety of bus architectures. The memory **204** may be one or more devices for storing data and/or computer code for completing or facilitating methods described herein. The memory **204** may include database components, object code components, script components, or other types of information structure for supporting the various activities herein. Any distributed or local memory device may be utilized with the systems and methods of this description. The memory **204** may be communicably connected to the processor device **202** (e.g., via a circuit or any other wired, wireless, or network connection) and may include computer code for executing one or more processes described herein. The memory **204** may include non-volatile memory **208** (e.g., read-only memory (ROM), erasable programmable read-only memory (EPROM), electrically erasable programmable read-only memory (EEPROM), etc.), and volatile memory **210** (e.g., random-access memory (RAM)), or any other medium which can be used to carry or store desired program code in the form of machine-executable instructions or data structures and which can be accessed by a computer or other machine with a processor device **202.** A basic input/output system (BIOS) **212** may be stored in the non-volatile memory **208** and can include the basic routines that help to transfer information between elements within the computer system **200.**

The computer system **200** may further include or be coupled to a non-transitory computer-readable storage medium such as the storage device **214,** which may comprise, for example, an internal or external hard disk drive (HDD) (e.g., enhanced integrated drive electronics (EIDE) or serial advanced technology attachment (SATA)), HDD (e.g., EIDE or SATA) for storage, flash memory, or the like. The storage device **214** and other drives associated with computer-readable media and computer-usable media may provide non-volatile storage of data, data structures, computer-executable instructions, and the like.

A number of modules can be implemented as software and/or hard-coded in circuitry to implement the functionality described herein in whole or in part. The modules may be stored in the storage device **214** and/or in the volatile memory **210,** which may include an operating system **216** and/or one or more program modules **218.** All or a portion of the examples disclosed herein may be implemented as a computer program product **220** stored on a transitory or non-transitory computer-usable or computer-readable storage medium (e.g., single medium or multiple media), such as the storage device **214,** which includes complex programming instructions (e.g., complex computer-readable program code) to cause the processor device **202** to carry out the steps described herein. Thus, the computer-readable program code can comprise software instructions for implementing the functionality of the examples described herein when executed by the processor device **202.** The processor device **202** may serve as a controller or control system for the computer system **200** that is to implement the functionality described herein.

The computer system **200** also may include an input device interface **222** (e.g., input device interface and/or output device interface). The input device interface **222** may be configured to receive input and selections to be communicated to the computer system **200** when executing instructions, such as from a keyboard, mouse, touch-sensitive surface, etc. Such input devices may be connected to the processor device **202** through the input device interface **222** coupled to the system bus **206** but can be connected through other interfaces such as a parallel port, an Institute of Electrical and Electronic Engineers (IEEE) 1394 serial port, a Universal Serial Bus (USB) port, an IR interface, and the like. The computer system **200** may include an output device interface **224** configured to forward output, such as to a display, a video display unit (e.g., a liquid crystal display (LCD) or a cathode ray tube (CRT)). The computer system **200** may also include a communications interface **226** suitable for communicating with a network as appropriate or desired.

The operational steps described in any of the exemplary aspects herein are described to provide examples and discussion. The steps may be performed by hardware components, may be embodied in machine-executable instructions to cause a processor to perform the steps, or may be performed by a combination of hardware and software. Although a specific order of method steps may be shown or described, the order of the steps may differ. In addition, two or more steps may be performed concurrently or with partial concurrence.

The terminology used herein is for the purpose of describing particular aspects only and is not intended to be limiting of the disclosure. As used herein, the singular forms "a," "an," and "the" are intended to include the plural forms as well, unless the context clearly indicates otherwise. As used herein, the term "and/or" includes any and all combinations of one or more of the associated listed items. It will be further understood that the terms "comprises," "comprising," "includes," and/or "including" when used herein specify the presence of stated features, integers, steps, operations, elements, and/or components, but do not preclude the presence or addition of one or more other features, integers, steps, operations, elements, components, and/or groups thereof.

It will be understood that, although the terms first, second, etc., may be used herein to describe various elements, these elements should not be limited by these terms. These terms are only used to distinguish one element from another. For example, a first element could be termed a second element, and, similarly, a second element could be termed a first element without departing from the scope of the present disclosure.

Relative terms such as "below" or "above" or "upper" or "lower" or "horizontal" or "vertical" may be used herein to describe a relationship of one element to another element as illustrated in the Figures. It will be understood that these terms and those discussed above are intended to encompass different orientations of the device in addition to the orientation depicted in the Figures. It will be understood that when an element is referred to as being "connected" or "coupled" to another element, it can be directly connected or coupled to the other element, or intervening elements may be present. In contrast, when an element is referred to as being "directly connected" or "directly coupled" to another element, there are no intervening elements present.

Unless otherwise defined, all terms (including technical and scientific terms) used herein have the same meaning as commonly understood by one of ordinary skill in the art to which this disclosure belongs. It will be further understood that terms used herein should be interpreted as having a meaning consistent with their meaning in the context of this specification and the relevant art and will not be interpreted in an idealized or overly formal sense unless expressly so defined herein.

It is to be understood that the present disclosure is not limited to the aspects described above and illustrated in the drawings; rather, the skilled person will recognize that many changes and modifications may be made within the scope of the present disclosure and appended claims. In the drawings and specification, there have been disclosed aspects for purposes of illustration only and not for purposes of limitation, the scope of the inventive concepts being set forth in the following claims.

## Claims

1. A computer system **(200)** comprising a processor device **(202)** configured to:
determining **(S10)** a requested take-off of a parked electric vehicle **(1);**
determining **(S20)** a battery temperature (**T_{B}**) of at least one battery cell **(30)** of the electric vehicle **(1);**
determining **(S30)** an ambient temperature (**T_{A}**) of the electric vehicle **(1);**
determining **(S40)** a thermal activity state (**T_{AS}**) of at least one battery cell **(30)** as the difference between the battery temperature (**T_{B}**) and the ambient temperature (**T_{A}**); and
preventing **(S50)** the requested take-off when the thermal activity state (**T_{AS}**) is above a predetermined thermal activity state threshold (**T_{AST}**).

2. A computer-implemented method (110), comprising:
determining **(S10),** by a processor device **(202)** of a computer system **(200),** a requested take-off of a parked electric vehicle **(1);**
determining **(S20),** by the processor device **(202),** a battery temperature (**T_{B}**) of at least one battery cell **(10)** of the electric vehicle **(1);**
determining **(S30),** by the processor device **(202),** an ambient temperature (**T_{A}**) of the electric vehicle **(1);**
determining **(S40),** by the processor device **(202),** a thermal activity state (**T_{AS}**) of at least one battery cell **(10)** as the difference between the battery temperature (**T_{B}**) and the ambient temperature (**T_{A}**); and
preventing **(S50),** by the processor device **(202),** the requested take-off when the thermal activity state (**T_{AS}**) is above a predetermined thermal activity state threshold (**T_{AST}**).

3. The method of claim 2, further comprising:
allowing **(S60),** by the processor device **(202),** the requested take-off when the battery temperature (**T_{B}**) is above a predetermined battery temperature threshold (**T_{BT}**) and when the thermal activity state (**T_{AS}**) is below the predetermined thermal activity state threshold (**T_{AST}**).

4. The method of any of claims 2-3, wherein:
determining **(S20)** the battery temperature (**T_{B}**) of at least one battery cell **(10)** of the electric vehicle **(1)** is performed by means of at least one sensor **(50)** mounted on at least one battery cell **(10).**

5. The method of any of claims 2-4, wherein:
determining **(S20)** the battery temperature (**T_{B}**) of at least one battery cell **(10)** of the electric vehicle **(1)** is performed by means of at least one sensor **(50)** mounted on at least one battery module **(20).**

6. The method of any of claims 2-5, wherein:
determining **(S20)** the battery temperature (**T_{B}**) of at least one battery cell **(10)** of the electric vehicle **(1)** is performed by means of at least one sensor **(50)** mounted on at least one battery pack **(30).**

7. The method of any of claims 2-6, wherein:
determining **(S30)** the ambient temperature (**T_{A}**) of at least one battery cell **(10)** of the electric vehicle **(1)** is performed by means of at least one ambient sensor **(60)** mounted remote, or on the exterior, of at least one battery pack **(30).**

8. The method of any of claims 2-7, wherein:
preventing **(S50)** the requested take-off is performed by disconnecting the at least one battery cell **(10).**

9. The method of any of claims 2-8, further comprising:
determining **(S20)** the battery temperature (**T_{B}**) of at least one battery cell **(10)** of the electric vehicle **(1)** as an average value of a plurality of battery temperature (**T_{B}**) values.

10. The method of any of claims 2-8, further comprising:
determining **(S20)** the battery temperature (**T_{B}**) of at least one battery cell **(10)** of the electric vehicle **(1)** as a maximum value of a plurality of battery temperature (**T_{B}**) values.

11. The method of claim 2, further comprising:
allowing **(S60),** by the processor device **(202),** the requested take-off when the battery temperature (**T_{B}**) is above a predetermined battery temperature threshold (**T_{BT}**) and when the thermal activity state (**T_{AS}**) is below the predetermined thermal activity state threshold (**T_{AST}**), wherein
determining **(S20)** the battery temperature (**T_{B}**) of at least one battery cell **(10)** of the electric vehicle **(1)** is performed by means of at least one sensor **(50)** mounted on at least one battery cell **(10),** battery module **(20),** or battery pack **(30),** wherein
determining **(S30)** the ambient temperature (**T_{A}**) of at least one battery cell **(10)** of the electric vehicle **(1)** is performed by means of at least one ambient sensor **(60)** mounted remote, or on the exterior, of at least one battery pack **(30),** wherein
preventing **(S50)** the requested take-off is performed by disconnecting the at least one battery cell **(10),** and wherein
determining **(S20)** the battery temperature (**T_{B}**) of at least one battery cell **(10)** of the electric vehicle **(1)** as an average value or a maximum value of a plurality of battery temperature (**T_{B}**) values.

12. An electric vehicle **(1)** comprising the processor device **(202)** to perform the method **(110)** of any of claims 2-11.

13. A computer program product **(220)** comprising program code for performing, when executed by the processor device **(202),** the method **(110)** of any of claims 2-11.

14. A control system **(300)** comprising one or more control units **(302)** configured to perform the method **(110)** of any of claims 2-11.

15. A non-transitory computer-readable storage medium comprising instructions, which when executed by the processor device **(202),** cause the processor device **(202)** to perform the method **(110)** of any of claims 2-11.
